(19) Europäisches Patentamt
European Patent Office
Office européen des brevets

(11) **EP 4 346 100 A1**

(12) **EUROPEAN PATENT APPLICATION**

(43) Date of publication:
**03.04.2024 Bulletin 2024/14**

(21) Application number: **23200357.4**

(22) Date of filing: **28.09.2023**

(51) International Patent Classification (IPC):
**H03H 9/00** *(2006.01)*   **H03H 9/02** *(2006.01)*
**H03H 9/205** *(2006.01)*   **H03H 9/58** *(2006.01)*

(52) Cooperative Patent Classification (CPC):
**H03H 9/0014; H03H 9/02015; H03H 9/205;
H03H 9/584; H03H 9/589**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **29.09.2022 US 202263411404 P
21.09.2023 US 202318371159**

(71) Applicant: **Qorvo US, Inc.
Greensboro, NC 27409 (US)**

(72) Inventors:
• **FATTINGER, Gernot
Apopka, Florida, 32703 (US)**
• **KOOHI, Milad Zolfagharloo
Apopka, Florida, 32703 (US)**

(74) Representative: **D Young & Co LLP
120 Holborn
London EC1N 2DY (GB)**

(54) **RECONFIGURABLE ACOUSTIC WAVE RESONATORS AND FILTERS**

(57)    Reconfigurable bulk acoustic wave (BAW) devices include one or more ferroelectric materials as the transduction layer(s). A polarization state of at least one of the ferroelectric material(s) is adjusted by applying a bias voltage across electrodes of the BAW device. The application of the bias voltage can change one or more properties of the ferroelectric material, which in turn may change a response of the BAW device.

FIG. 4

EP 4 346 100 A1

## Description

Related Applications

This application claims the benefit of U.S. provisional patent application serial number 63/411,404, filed September 29, 2022, the disclosure of which is hereby incorporated herein by reference in its entirety.

Field of the Disclosure

The present disclosure relates generally to bulk acoustic wave devices, such as bulk acoustic wave resonators and bulk acoustic wave filters. More particularly, the present disclosure relates to reconfigurable bulk acoustic wave devices.

Summary

Particular aspects are set out in the appended independent claims. Various optional embodiments are set out in the dependent claims.

Embodiments disclosed herein relate to acoustic wave device, such as an acoustic wave resonator and an acoustic wave filter. One example of an acoustic wave resonator is a bulk acoustic wave (BAW) resonator, and one example of an acoustic wave filter is a BAW filter. These devices are referred to herein as BAW devices. Embodiments described herein incorporate one or more ferroelectric materials in a BAW device as the transduction layer(s). The electromechanical coupling coefficient $K_e^2$ of a BAW resonator is a function of the piezoelectric coefficient (d) of the transduction layer, where (d) is a function of the material electric polarization (P). By applying a bias voltage across the electrodes of the BAW resonator, the polarization in the ferroelectric material is adjusted, which in turn changes a response of the BAW device. Thus, the BAW device is a reconfigurable BAW device. Additionally, although embodiments are described in conjunction with a reconfigurable BAW device, other embodiments are not limited to reconfigurable BAW devices. A reconfigurable surface-acoustic-wave (SAW) device, such as a SAW resonator or a SAW filter, can incorporate ferroelectric materials that operate as disclosed herein.

Those skilled in the art will appreciate the scope of the present disclosure and realize additional aspects thereof after reading the following detailed description of the illustrative embodiments in association with the accompanying drawing figures.

Brief Description of the Drawing Figures

The accompanying drawing figures incorporated in and forming a part of this specification illustrate several aspects of the disclosure, and together with the description serve to explain the principles of the disclosure.

FIG. 1 illustrates an example of a conventional first bulk acoustic wave (BAW) device;
FIG. 2 illustrates an example an example of a conventional second BAW device;
FIG. 3 illustrates multiple conventional first BAW devices operably connected to a carrier substrate;
FIG. 4 illustrates an example first reconfigurable BAW device in accordance with embodiments of the disclosure;
FIG. 5 illustrates the example first reconfigurable BAW device shown in FIG. 4 with a first reconfigurable resonator and a second reconfigurable resonator tuned to parallel polarization states in accordance with embodiments of the disclosure;
FIG. 6 illustrates the example first reconfigurable BAW device shown in FIG. 4 with the first reconfigurable resonator and the second reconfigurable resonator tuned to antiparallel polarization states in accordance with embodiments of the disclosure;
FIG. 7 illustrates an example second reconfigurable BAW device in accordance with embodiments of the disclosure;
FIG. 8 the example second reconfigurable BAW device shown in FIG. 7 with the first reconfigurable BAW transducer and the second reconfigurable BAW transducer tuned to parallel polarization states in accordance with embodiments of the disclosure;
FIG. 9 illustrates the example second reconfigurable BAW device shown in FIG. 7 with the first reconfigurable BAW transducer and the second reconfigurable BAW transducer tuned to antiparallel polarization states in accordance with embodiments of the disclosure;
FIG. 10 illustrates example plots of transmission phases of the second reconfigurable BAW device shown in FIG. 8 and FIG. 9 when both the first ferroelectric layer and the second ferroelectric layer are polarized to parallel polarization states and polarized to antiparallel states in accordance with embodiments of the disclosure;
FIG. 11 illustrates an example polarization-electric field (P-E) hysteresis loop 1100 of a ferroelectric material in accordance with embodiments of the disclosure;
FIG. 12 illustrates example plots that represent different transmission responses of the reconfigurable BAW devices shown in FIG. 4 through FIG. 9 in accordance with embodiments of the disclosure;
FIG. 13 illustrates an example third reconfigurable BAW device in accordance with embodiments of the disclosure;
FIG. 14 illustrates an example of cascaded first reconfigurable BAW devices in accordance with embodiments of the disclosure;
FIG. 15 illustrates an example fourth reconfigurable BAW device in accordance with embodiments of the disclosure;

FIG. 16 illustrates an example fifth reconfigurable BAW device in accordance with embodiments of the disclosure;

FIG. 17 illustrates an example sixth reconfigurable BAW device in accordance with embodiments of the disclosure;

FIG. 18 illustrates an example system that includes one or more reconfigurable BAW devices in accordance with embodiments of the disclosure;

FIG. 19 illustrates an example integrated circuit that includes multiple reconfigurable BAW devices in accordance with embodiments of the disclosure;

FIG. 20 illustrates an example conventional radio frequency (RF) front-end system that includes BAW devices; and

FIG. 21 illustrates an example RF front-end system that includes reconfigurable BAW devices in accordance with embodiments of the disclosure.

Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments are described herein with reference to schematic illustrations of embodiments of the disclosure. As such, the actual dimensions of the layers and elements can be different, and variations from the shapes of the illustrations as a result, for example, of manufacturing techniques and/or tolerances, are expected. For example, a region illustrated or described as square or rectangular can have rounded or curved features, and regions shown as straight lines may have some irregularity. Thus, the regions illustrated in the figures are schematic and their shapes are not intended to illustrate the precise shape of a region of a device and are not intended to limit the scope of the disclosure. Additionally, sizes of structures or regions may be exaggerated relative to other structures or regions for illustrative purposes and, thus, are provided to illustrate the general structures of the present subject matter and may or may not be drawn to scale. Common elements between figures may be shown herein with common element numbers and may not be subsequently re-described.

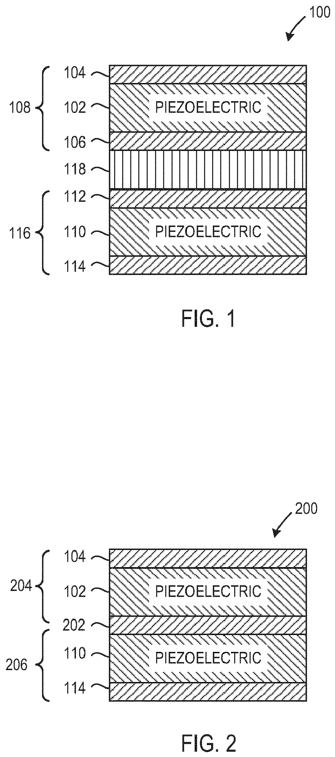

FIG. 1 illustrates an example of a conventional first BAW device 100. The conventional first BAW device 100 is an example of a coupled-resonator filter (CRF). The conventional first BAW device 100 includes a first piezoelectric layer 102 positioned between a first electrode 104 and a second electrode 106. The first piezoelectric layer 102, the first electrode 104, and the second electrode 106 form a first resonator 108. The conventional first BAW device 100 further includes a second piezoelectric layer 110 positioned between a third electrode 112 and a fourth electrode 114. The second piezoelectric layer 110, the third electrode 112, and the fourth electrode 114 form a second resonator 116. Non-limiting examples of a piezoelectric material is an aluminum nitride (AlN) material, a scandium aluminum nitride (ScAlN), a lead zirconate titanate (PZT) material, a zinc oxide (ZnO) material, or a zinc sulfur (ZnS) material. The first electrode 104, the second electrode 106, the third electrode 112, and the fourth electrode 114 may be made of one or more layers of any suitable conductive material. Example conductive materials include, but are not limited to, tungsten, aluminum, copper, molybdenum, or combinations thereof.

The conventional first BAW device 100 also includes a coupling layer 118 positioned between the first resonator 108 and the second resonator 116. In certain instances, the coupling layer 118 provides a desired acoustic coupling between the first resonator 108 and the second resonator 116.

FIG. 2 illustrates an example an example of a conventional second BAW device 200. The conventional second BAW device 200 is an example of a stacked crystal filter (SCF). The conventional second BAW device 200 is similar to the conventional first BAW device 100 shown in FIG. 1 but with the omission of the coupling layer 118, the second electrode 106, and the third electrode 112. The conventional second BAW device 200 includes the first piezoelectric layer 102, the first electrode 104, the second piezoelectric layer 110, and the fourth electrode 114. An intermediate electrode 202 is disposed between the first piezoelectric layer 102 and the second piezoelectric layer 110.

The first piezoelectric layer 102, the first electrode 104, and the intermediate electrode 202 form a first transducer 204. The second piezoelectric layer 110, the intermediate electrode 202, and the fourth electrode 114 form a second transducer 206. The intermediate electrode 202 may be made of one or more layers of any suitable conductive material. Example conductive materials include, but are not limited to, tungsten, aluminum, copper, molybdenum, or combinations thereof.

One limitation with the conventional first BAW device 100 shown in FIG. 1 and the second BAW device shown in FIG. 2 is that the properties of the first piezoelectric layer 102 and the second piezoelectric layer 110 are fixed once the fabrication of the conventional first BAW device 100 or the conventional second BAW device 200 is complete. The material properties of the first piezoelectric layer 102 and the second piezoelectric layer 110 are constant and cannot be modified after fabrication, which means the responses of the conventional first BAW device 100 and the conventional second BAW device 200 are fixed and unalterable. For example, the bandwidths of the conventional first BAW device 100 and the conventional second BAW device 200 are fixed and unalterable.

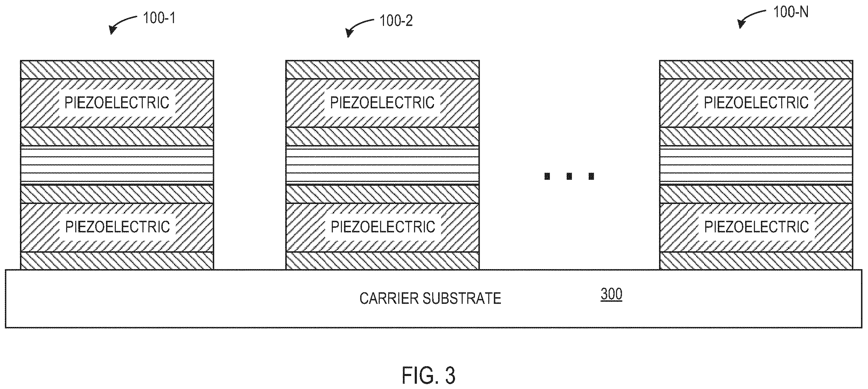

Due to the fixed material properties of the piezoelectric material, in some situations, an application must use multiple BAW devices when different filter response(s) are needed. FIG. 3 illustrates multiple conventional first BAW devices 100-1, 100-2, ..., 100-N operably connected to a carrier substrate 300. Although FIG. 3 depicts multiple conventional first BAW devices 100 (FIG. 1), other embodiments can use multiple conventional second BAW devices 200 (FIG. 2) or a combination of conventional first BAW devices 100 and conventional second BAW devices 200.

Each conventional first BAW device 100-1, 100-2, ..., 100-N is designed to have particular characteristics. Thus, in the illustrated embodiment, there are "N" BAW devices (N>1), and each conventional first BAW device 100-1, 100-2, ..., 100-N has one or more characteristics that differ from the characteristics of the other conventional BAW devices 100-1, 100-2, ..., 100-N. For example, each conventional first BAW device 100-1, 100-2, ..., 100-N can function as a band pass filter with a particular bandwidth (e.g., passes signals within a different range of frequencies). Because the conventional first BAW devices 100-1, 100-2, ..., 100-N are designed to have particular characteristics, each conventional first BAW device 100-1, 100-2, ..., 100-N is fabricated independent of the other conventional first BAW devices 100-1, 100-2, ..., 100-N. Thus, when N=3, three separate fabrication processes are performed to produce the three separate conventional first BAW devices 100-1, 100-2, 100-3. This increases the cost and/or the complexity of fabricating the conventional first BAW devices 100-1, 100-2, 100-3.

Additionally, because the conventional first BAW devices 100-1, 100-2, ..., 100-N are distinct devices, the conventional first BAW devices 100-1, 100-2, ..., 100-N are operably connected to the carrier substrate 300. The carrier substrate 300 enables the conventional first BAW devices 100-1, 100-2, ..., 100-N to be operably connected each other. One challenge with the distinct conventional first BAW devices 100-1, 100-2, ..., 100-N and the use of the carrier substrate 300 is the amount of area or space in an electronic device that is consumed by the conventional first BAW devices 100-1, 100-2, ..., 100-N and the carrier substrate 300. In some instances, the conventional first BAW devices 100-1, 100-2, ..., 100-N and the carrier substrate 300 can require a relatively large amount of area in an electronic device.

Embodiments disclosed herein provide reconfigurable BAW devices. One or more properties of a reconfigurable BAW device can be set or adjusted after the BAW device is fabricated, which allows the response of the BAW device to be changed once the BAW device is in use. The reconfigurable BAW device includes a ferroelectric layer instead of a piezoelectric layer. A power supply that is operably connected to the reconfigurable BAW device is operable to apply a particular voltage, such as a direct current (DC) voltage, across the ferroelectric layer. The amount of voltage output by the power supply can be changed to modify one or more properties of the ferroelectric material in the ferroelectric layer. The change in the property (or properties) of the ferroelectric material changes the response of the reconfigurable BAW device. In certain embodiments, the power supply can be removed (e.g., disabled or disconnected) after the material property is adjusted.

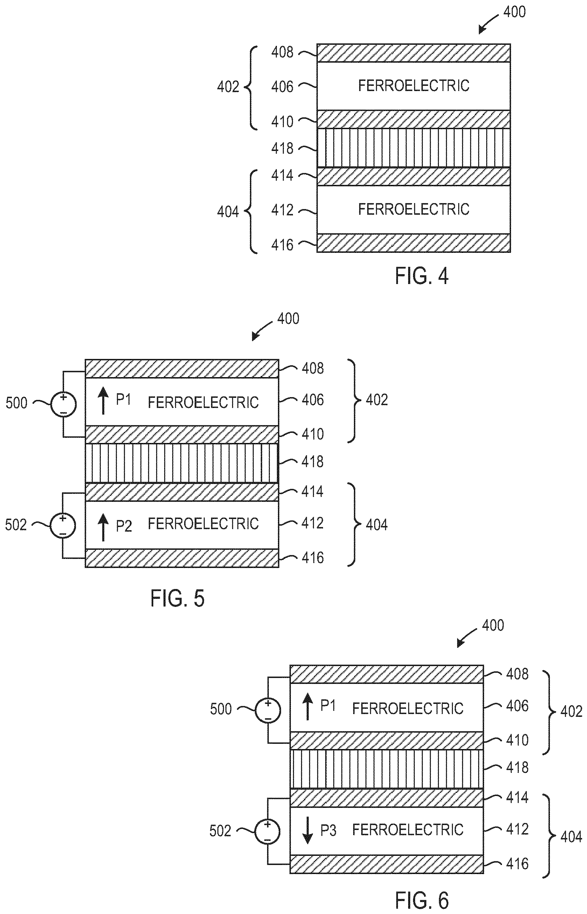

FIG. 4 illustrates an example first reconfigurable BAW device 400 in accordance with embodiments of the disclosure. The first reconfigurable BAW device 400 includes a first reconfigurable BAW resonator 402 stacked vertically over a second reconfigurable BAW resonator 404. The example first reconfigurable BAW device 400 is an example of a CRF.

The first reconfigurable BAW resonator 402 includes a first ferroelectric layer 406 positioned between a first electrode 408 and a second electrode 410. The second reconfigurable BAW resonator 404 includes a second ferroelectric layer 412 positioned between a third electrode 414 and a fourth electrode 416. The first electrode 408, the second electrode 410, the third electrode 414, and the fourth electrode 416 may each be made of one or more layers of any suitable conductive material. Example conductive materials include, but are not limited to, tungsten, aluminum, copper, molybdenum, or combinations thereof. Non-limiting examples of a ferroelectric material for the first ferroelectric layer 406 and the second ferroelectric layer 412 is lead titanate ($PbTiO_3$), PZT, barium titanate (BTO), strontium titanate (STO), tin zinc oxide ($SnZnO_3$), and scandium aluminum nitride (ScAlN).

An acoustic coupling layer 418 ("coupling layer 418") is provided between the first reconfigurable BAW resonator 402 and the second reconfigurable BAW resonator 404. In particular, the coupling layer 418 is between the second electrode 410 of the first reconfigurable BAW resonator 402 and the third electrode 414 of the second reconfigurable BAW resonator 404. The coupling layer 418 is operable to acoustically couple the first reconfigurable BAW resonator 402 and the second reconfigurable BAW resonator 404 for one or more acoustic wavelengths or ranges thereof. In a representative embodiment, the coupling layer 418 can be any dielectric material including but not limited to silicon dioxide ($SiO_2$) or silicon nitride (SiN). The coupling material can also be multilayers that include dielectric and metal layers.

FIG. 5 illustrates the example first reconfigurable BAW device 400 shown in FIG. 4 with the first ferroelectric layer 406 and the second ferroelectric layer 412 tuned to parallel polarization states in accordance with embodiments of the disclosure. Generally, one port or terminal of a first power supply 500 is operably connected to the first electrode 408 and the other terminal of the first power supply 500 is operably connected to the second electrode 410. Additionally or alternatively, one terminal of a second power supply 502 is operably connected to the third electrode 414 and the other terminal of the second power supply 502 is operably connected to the fourth electrode 416. For example, in the illustrated embodiment, a positive terminal of the first power supply 500 is operably connected to the first electrode 408 and a negative terminal of the first power supply 500 is operably connected to the second electrode 410. The positive terminal of the second power supply 502 is operably connected to the third electrode 414 and the negative terminal of the second power supply 502 is operably connected to the fourth electrode 416. In other embodiments, the port connections of the first power supply 500 and/or the second power supply 502 can be different.

In a non-limiting example, the first power supply 500 and the second power supply 502 are DC power supplies. In other embodiments, only the first power supply 500 or the second power supply 502 is operably connected to the first reconfigurable BAW device 400. The first power supply 500 and/or the second power supply 502 can be removed or disabled after the respective ferroelectric layer 406 or 412 (or first ferroelectric layer 406 and second ferroelectric layer 412) is biased to a desired polarization state.

An electric polarization of the first ferroelectric layer 406 and an electric polarization of the second ferroelectric layer 412 can each be tuned to a particular polarization state or changed from a first polarization state to a second polarization state through the application of an external electric field across the first ferroelectric layer 406 and the second ferroelectric layer 412. In certain embodiments, the electric field is produced by applying a DC voltage across the first ferroelectric layer 406 and/or across the second ferroelectric layer 412. As will be described in more detail later, a change in the polarization state of the first ferroelectric layer 406 changes one or more material properties of the ferroelectric material in the first ferroelectric layer 406, where one material property is an electromechanical coupling coefficient ($K^2_e$) of the ferroelectric material. Similarly, a change in the polarization state of the second ferroelectric layer 412 changes the electromechanical coupling coefficient ($K^2_e$) of the ferroelectric material in the second ferroelectric layer 412. The change in the one or more material properties of the first ferroelectric layer 406 and/or the second ferroelectric layer 412 produces a change in the response of the first reconfigurable BAW device 400.

In FIG. 5, the polarization state of the first ferroelectric layer 406 is tuned to a positive first polarization state P1 using the first power supply 500, and the polarization state of the second ferroelectric layer 412 is tuned to a positive second polarization state P2 using the second power supply 502. The first polarization state P1 and the second polarization state P2 are parallel polarization states in that the first polarization state P1 and the second polarization state P2 are both positive polarization states. The value of P1 and the value of P2 can be the same, or the value of P1 and the value of P2 may differ from one another. The value of P1, and the first polarization state of the first ferroelectric layer 406, are tunable (e.g., adjustable) using the first power supply 500. The value of P2, and the second polarization state of the second ferroelectric layer 412, are tunable using the second power supply 502.

In other embodiments, the first power supply 500 or the second power supply 502 may be omitted. As such, only one power supply is used to adjust one or more material properties of a respective ferroelectric layer.

FIG. 6 illustrates the example first reconfigurable BAW device 400 shown in FIG. 4 with the first reconfigurable BAW resonator 402 and the second reconfigurable BAW resonator 404 tuned to antiparallel polarization states in accordance with embodiments of the disclosure. The polarization state of the first ferroelectric layer 406 is tuned to the positive first polarization state P1 using the first power supply 500, and the polarization state of the second ferroelectric layer 412 is tuned to a negative third polarization state P3 using the second power supply 502. The first polarization state P1 and the third polarization state P3 are antiparallel polarization states in that the first polarization state P1 is a positive polarization state and the third polarization state P3 is a negative polarization state. In the illustrated example, the value of P1 and the value of P3 are different from one another. As discussed earlier, the value of P1, and the first polarization state of the first ferroelectric layer 406, are tunable (e.g., adjustable) using the first power supply 500. The value of P3, and the third polarization state of the second ferroelectric layer 412, are tunable using the second power supply 502.

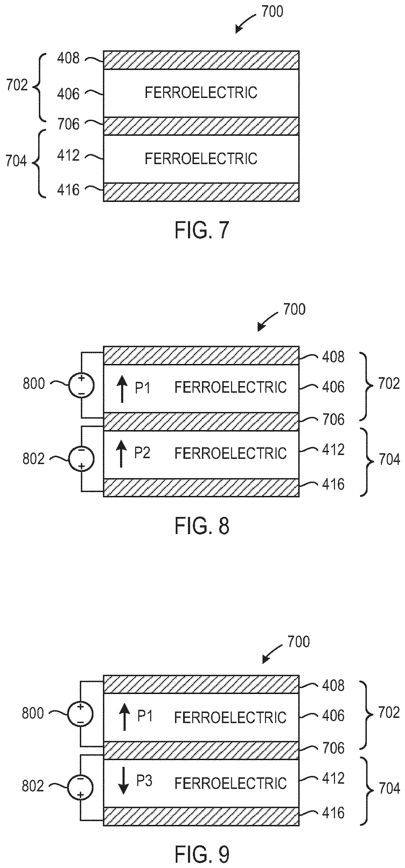

FIG. 7 illustrates an example second reconfigurable BAW device 700 in accordance with embodiments of the disclosure. The second reconfigurable BAW device 700 includes a first reconfigurable BAW transducer 702 stacked vertically over a second reconfigurable BAW transducer 704. The second reconfigurable BAW device 700 is an example of an SCF.

The first reconfigurable BAW transducer 702 includes the first ferroelectric layer 406 positioned between the first electrode 408 and an intermediate electrode 706. The second reconfigurable BAW transducer 704 includes the second ferroelectric layer 412 positioned between the intermediate electrode 706 and the fourth electrode 416. Non-limiting examples of a conductive material for the intermediate electrode 706 include tungsten, aluminum, copper, molybdenum, or combinations thereof.

FIG. 8 illustrates the example second reconfigurable BAW device 700 shown in FIG. 7 with the first reconfigurable BAW transducer 702 and the second reconfigurable BAW transducer 704 tuned to parallel polarization states in accordance with embodiments of the disclosure. Generally, one port or terminal of a third power supply 800 is operably connected to the first electrode 408 and the other terminal of the third power supply 800 is operably connected to the intermediate electrode 706. Additionally or alternatively, one terminal of a fourth power supply 802 is operably connected to the intermediate electrode 706 and the other terminal of the fourth power supply 802 is operably connected to the fourth electrode 416. For example, in the illustrated embodiment, a positive terminal of the third power supply 800 is operably connected to the first electrode 408 and a negative terminal of the third power supply 800 is operably connected to the intermediate electrode 706. The negative terminal of the fourth power supply 802 is operably connected to the intermediate electrode 706 and the positive terminal of the fourth power supply 802 is operably connected to the fourth electrode 416. In other embodiments, the port connections of the third power supply 800 and/or the fourth power supply 802 can be different.

In a non-limiting example, the third power supply 800 and the fourth power supply 802 are DC power supplies. In other embodiments, only the third power supply 800 or the fourth power supply 802 is operably connected to the second reconfigurable BAW device 700. In certain embodiments, the third power supply 800 and/or the fourth power supply 802 can be removed or disabled after biasing the corresponding ferroelectric layer (e.g., ferroelectric layer 406 and/or ferroelectric layer 412) to a desired polarization state.

As described previously, the electric polarization of the first ferroelectric layer 406 and the electric polarization of the second ferroelectric layer 412 can each be tuned to a particular polarization state or changed from a first polarization state to a second polarization state through the application of an external electric field across the first ferroelectric layer 406 and the second ferroelectric layer 412. In certain embodiments, the electric field is produced by applying a DC voltage across the first ferroelectric layer 406 and/or across the second ferroelectric layer 412. As will be described in more detail later, a change in the polarization state of the first ferroelectric layer 406 changes one or more material properties of the ferroelectric material of the first ferroelectric layer 406, where one material property is the electromechanical coupling coefficient ($K^2_e$) of the ferroelectric material. Similarly, a change in the polarization state of the second ferroelectric layer 412 changes one or more material properties of the ferroelectric material of the second ferroelectric layer 412, where one material property is the electromechanical coupling coefficient ($K^2_e$) of the ferroelectric material. The change in the one or more material properties of the first ferroelectric layer 406 and/or the one or more material properties of the second ferroelectric layer 412 produces a change in the response of the second reconfigurable BAW device 700.

In FIG. 8, the polarization state of the first ferroelectric layer 406 is tuned to the positive first polarization state P1 using the third power supply 800, and the polarization state of the second ferroelectric layer 412 is tuned to the positive second polarization state P2 using the fourth power supply 802. The value of P1 and the value of P2 can be the same, or the value of P1 and the value of P2 may differ from one another. The value of P1, and the polarization state of the first ferroelectric layer 406, are tunable (e.g., adjustable) using the third power supply 800. The value of P2, and the polarization state of the second ferroelectric layer 412, are tunable using the fourth power supply 802.

FIG. 9 illustrates the example second reconfigurable BAW device 700 shown in FIG. 7 with the first reconfigurable BAW transducer 702 and the second reconfigurable BAW transducer 704 tuned to antiparallel polarization states in accordance with embodiments of the disclosure. The polarization state of the first ferroelectric layer 406 is tuned to a positive first polarization state P1 using the third power supply 800, and the polarization state of the second ferroelectric layer 412 is tuned to the negative third polarization state P3 using the fourth power supply 802. In the illustrated example, the value of P1 and the value of P3 are different from one another. The value of P1, and the polarization state of the first ferroelectric layer 406, are tunable (e.g., adjustable) using the third power supply 800. The value of P3, and the polarization state of the second ferroelectric layer 412, are tunable using the fourth power supply 802. The transmission phase of the second reconfigurable BAW device 700 can be changed by switching the polarization state of the first ferroelectric layer 406 and/or the second ferroelectric layer 412.

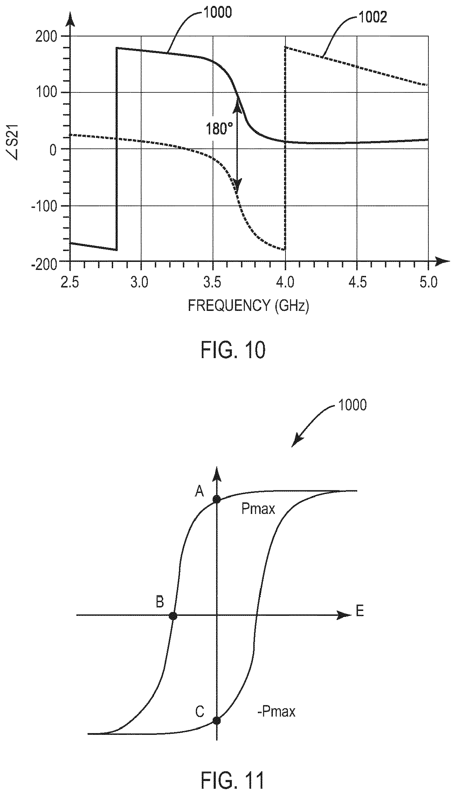

FIG. 10 illustrates example plots of transmission phases of the second reconfigurable BAW device 700 shown in FIG. 8 and FIG. 9 when both the first ferroelectric layer 406 and the second ferroelectric layer 412 are polarized to parallel polarization states and polarized to antiparallel states in accordance with embodiments of the disclosure. A plot 1000 depicts a transmission phase of the second reconfigurable BAW device 700 when the first ferroelectric layer 406 and the second ferroelectric layer 412 are tuned to parallel polarization states (e.g., positive polarization states). A plot 1002 depicts a transmission phase of the second reconfigurable BAW device 700 when the first ferroelectric layer 406 and the second ferroelectric layer 412 are tuned to antiparallel polarization states. In FIG. 10, the change in the transmission phase between plot 1000 and plot 1002 is one hundred and eighty (180) degrees. Thus, the transmission phases of the second reconfigurable BAW device 700 can be switched by one hundred and eighty (180) degrees by switching the polarization states of the first ferroelectric layer 406 and the polarization state of the second ferroelectric layer 412 from a parallel polarization state to an antiparallel polarization state (or vice versa).

FIG. 11 illustrates an example polarization-electric field (P-E) hysteresis loop 1100 of a ferroelectric material in accordance with embodiments of the disclosure. The example P-E hysteresis loop 1100 is a plot of the polarization (P) in the ferroelectric material to the applied electric field (E). The polarization state of the ferroelectric material can be set to any polarization state along the P-E hysteresis loop 1100 based on the electric field applied across the ferroelectric material. For example, when the applied electric field is at a first magnitude, the polarization state of the ferroelectric material is at a positive maximum polarization state (point A). The polarization state of the ferroelectric material is at zero (point B) when the applied electric field is at a second magnitude. When the applied electric field is at a third magnitude, the polarization state of the ferroelectric material is at a negative maximum polarization state (point C). The polarization state of the ferroelectric material can be tuned to any other point along the P-E hysteresis loop 1100 based on the magnitude of the applied electric field. A P-E hysteresis loop, such as the P-E hysteresis loop 1100, can be used to tune the polarization state of the first ferroelectric layer 406 and/or the second ferroelectric layer 412.

As described earlier, a change in the polarization state of the first ferroelectric layer 406 and/or the second ferroelectric layer 412 in the first reconfigurable BAW device 400 (FIG. 4) changes the electromechanical coupling coefficient ($K^2_e$) of the ferroelectric material in the respective ferroelectric layer(s), which in turn adjusts the response of the first reconfigurable BAW device 400. Similarly, a change in the polarization state of the first ferroelectric layer 406 and/or the second ferroelectric layer 412 in the second reconfigurable BAW device 700 (FIG. 7) changes the electromechanical coupling coefficient ($K^2_e$) of the ferroelectric material in the respective ferroelectric layer(s), which in turn adjusts the response of the second reconfigurable BAW device 700. The application of different electric fields across the first ferroelectric layer 406 and/or the second ferroelectric layer 412 enables the electromechanical coupling coefficient of that ferroelectric layer to be tuned to a given value. Thus, the electromechanical coupling coefficient of the first ferroelectric layer 406 can be different from the electromechanical coupling coefficient of the second ferroelectric layer 412. Based on the electric field applied across the first ferroelectric layer 406, the electromechanical coupling coefficient of the first ferroelectric layer 406 may be tuned to any particular value. Based on the electric field applied across the second ferroelectric layer 412, the electromechanical coupling coefficient of the second ferroelectric layer 412 can be tuned to any particular value.

As discussed previously, once the ferroelectric material in the first ferroelectric layer 406 and/or in the second ferroelectric layer 412 is tuned to a particular polarization state, the voltage applied to the ferroelectric material (e.g., a DC bias voltage) is no longer required. Since the ferroelectric material is in its ferroelectric phase, the ferroelectric material holds the polarization state after removal or disablement of the bias voltage.

As described earlier, the electromechanical coupling coefficient of the first ferroelectric layer 406 and the electromechanical coupling coefficient of the second ferroelectric layer 412 are tunable through adjustments to the electric field applied across the first ferroelectric layer 406 and the second ferroelectric layer 412. The bandwidth of the first reconfigurable BAW device 400 and the bandwidth of the second reconfigurable BAW device 700 change in response to an adjustment of the respective electromechanical coupling coefficients. Thus, the bandwidth of the first reconfigurable BAW device 400 and the bandwidth of the second reconfigurable BAW device 700 are tunable.

The amount of polarization variation can be determined according to a respective P-E hysteresis loop, such as the P-E hysteresis loop 1100 shown in FIG. 11. For example, by moving to P = Pmax (point A) or -Pmax (point C), a reconfigurable BAW resonator or a reconfigurable BAW transducer operates in "on" states and acts as a regular acoustic wave resonator or transducer with a maximum electromechanical coupling coefficient ($K_{e,max}^2$). However, by moving to P=0 (point B) through a voltage applied across the electrodes of the reconfigurable BAW resonator or the reconfigurable BAW transducer by the power supply (e.g., first power supply 500 in FIG. 5 or third power supply 800 in FIG. 8), the electromechanical coupling becomes zero and the reconfigurable BAW resonator or the reconfigurable BAW transducer no longer acts as a resonator or transducer, respectively. In any intermediate polarization, the reconfigurable BAW resonator or the reconfigurable BAW transducer has an electromechanical coupling coefficient of $K_{e,1}^2$, where $0 < K_{e,1}^2 < K_{e,max}^2$. Therefore, the $K_e^2$ of the reconfigurable BAW resonator or the reconfigurable BAW transducer can be tuned with the voltage applied by the power supply. Additionally, the reconfigurable BAW resonator or the reconfigurable BAW transducer may be turned off by tuning the polarization to zero.

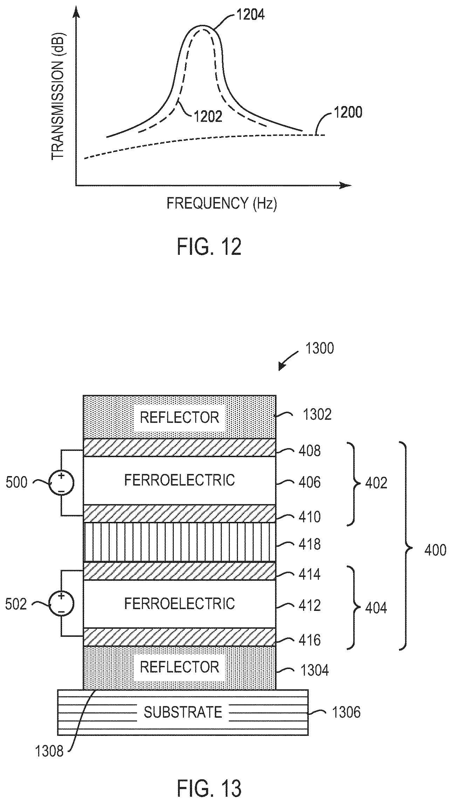

FIG. 12 illustrates example plots that represent different transmission responses of the reconfigurable BAW devices shown in FIG. 4 though FIG. 9 in accordance with embodiments of the disclosure. A response of a reconfigurable BAW device may be turned on, adjusted, or turned off by changing the one or more material properties in one or more ferroelectric layers of the reconfigurable BAW device. In one non-limiting nonexclusive example, the polarization state of at least one ferroelectric layer is adjusted to reduce or stop the transduction mechanism in a reconfigurable BAW resonator or in a reconfigurable BAW transducer to turn off the response of the reconfigurable BAW device. This "off" state is represented by a plot 1200 in FIG. 12. To produce the plot 1200, the polarization state of at least one ferroelectric layer may be tuned to zero.

In another non-limiting nonexclusive example, the polarization state of one or more ferroelectric layer can be tuned to change the electromechanical coupling in the ferroelectric layer(s), which in turn adjusts the bandwidth of the reconfigurable BAW device. A plot 1202 illustrates one example mid-range bandwidth of a reconfigurable BAW device operating as a bandpass filter. To produce the plot 1202, the polarization state of at least one ferroelectric layer may be tuned to an intermediate polarization state.

A plot 1204 depicts another example bandwidth of a reconfigurable BAW device operating as a bandpass filter with wider bandwidth. To produce the plot 1204, the polarization state of at least one ferroelectric layer may be tuned to a higher mid-range polarization or to a maximum polarization state (when compared to the plot 1202).

FIG. 13 illustrates an example third reconfigurable BAW device 1300 in accordance with embodiments of the disclosure. The third reconfigurable BAW device 1300 includes the first reconfigurable BAW device 400 shown in FIG. 4 through FIG. 6. A first reflector 1302 is operably connected to the first electrode 408. A second reflector 1304 is operably connected to the fourth electrode 416. A substrate 1306 is arranged over a surface 1308 of the second reflector 1304. Example materials for the substrate 1306 include, but are not limited to, glass or silicon.

The first reflector 1302 and the second reflector 1304 can each be implemented as any type of reflector. In non-limiting nonexclusive examples, the first reflector 1302 may be a Bragg reflector, an air reflector, or a vacuum reflector, and the second reflector 1304 may be a Bragg reflector, an air reflector, or a vacuum reflector. The first reflector 1302 and the second reflector 1304 can be the same type of reflector or the first reflector 1302 can differ from the second reflector 1304. In certain embodiments, the third reconfigurable BAW device 1300 includes only one reflector and omits the other reflector. For example, the third reconfigurable BAW device 1300 can include the second reflector 1304 and not the first reflector 1302 (or vice versa). In certain embodiments, the first reflector 1302 and/or the second reflector 1304 are realized with alternating layers of different material (e.g., SiO2 and Tungestan (W), and/or Aluminum (AlN) and W, etc.), which is called Bragg Reflector.

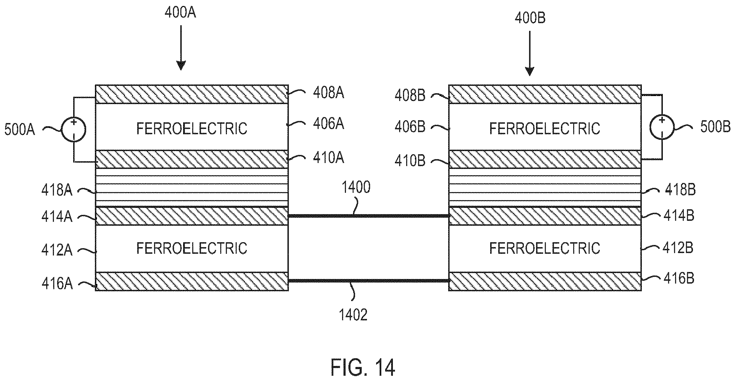

In some embodiments, multiple reconfigurable BAW devices can be cascaded to achieve a desired filter response. FIG. 14 illustrates an example of cascaded first reconfigurable BAW devices 400A, 400B in accordance with embodiments of the disclosure. Two cascaded first reconfigurable BAW devices 400A, 400B are operably connected to each other by a first electrical connector 1400 and by a second electrical connector 1402. The first electrical connector 1400 operably connects the third electrode 414A of the first reconfigurable BAW device 400A to the third electrode 414B of the first reconfigurable BAW device 400B, and the second electrical connector 1402 operably connects the fourth electrode 416A of the first reconfigurable BAW device 400A to the fourth electrode 416B of the first reconfigurable BAW device 400B. In some applications, more than two reconfigurable BAW devices may be cascaded.

In FIG. 14, the first power supply 500A is operably connected to the first electrode 408A and to the second electrode 410A of the first reconfigurable BAW device 400A. The first power supply 500B is operably connected to the first electrode 408B and to the second electrode 410B of the first reconfigurable BAW device 400B. In other embodiments, the first power supplies 500A, 500B may be omitted and the second power supply 502 (FIG. 5) can be operably connected to the second reconfigurable BAW resonator (e.g., the second reconfigurable BAW resonator 404 in FIG. 5). Alternatively, only one of the first power supplies (e.g., the first power supply 500A) may be operably connected to one of the first reconfigurable BAW devices (e.g., the first reconfigurable BAW device 400A). Alternatively, the first power supply 500A, the first power supply 500B, and the second power supply 502 can be connected together. In such embodiments, the first power supply 500A, the first power supply 500B, and the second power supply 502 can be removed or disabled after the first ferroelectric layers 406A, 406B and/or the second ferroelectric layers 412A, 412B are biased to the desired polarization state.

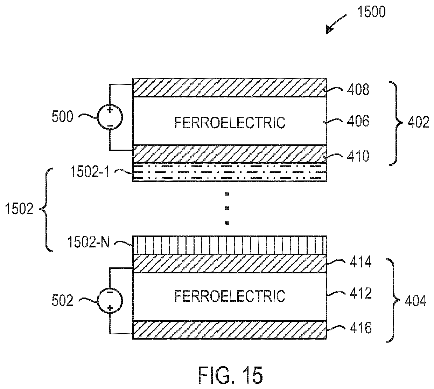

FIG. 15 illustrates an example fourth reconfigurable BAW device 1500 in accordance with embodiments of the disclosure. The fourth reconfigurable BAW device 1500 includes the first reconfigurable BAW resonator 402 stacked vertically over the second reconfigurable BAW resonator 404. A coupling structure 1502 is disposed between the first reconfigurable BAW resonator 402 and the second reconfigurable BAW resonator 404. In particular, the coupling structure 1502 is between the second electrode 410 of the first reconfigurable BAW resonator 402 and the third electrode 414 of the second reconfigurable BAW resonator 404. The coupling structure 1502 is operable to acoustically couple the first reconfigurable BAW resonator 402 and the second reconfigurable BAW resonator 404 for one or more acoustic wavelengths or ranges thereof.

The coupling structure 1502 includes N coupling layers 1502-1, ..., 1502-N, where N is greater than one. In certain embodiments, each coupling layer 1502-1, ..., 1502-N is made of a material that differs from the material in the other coupling layers 1502-1, ..., 1502-N in the coupling structure 1502. In other embodiments, the material in at least one coupling layer differs from the material in the other coupling layers. In a non-limiting example, the coupling layer 1502-1 can be any dielectric material including but not limited to $SiO_2$ and the coupling layer 1502-N can comprise SiN. Other types of coupling materials can be used in other embodiments.

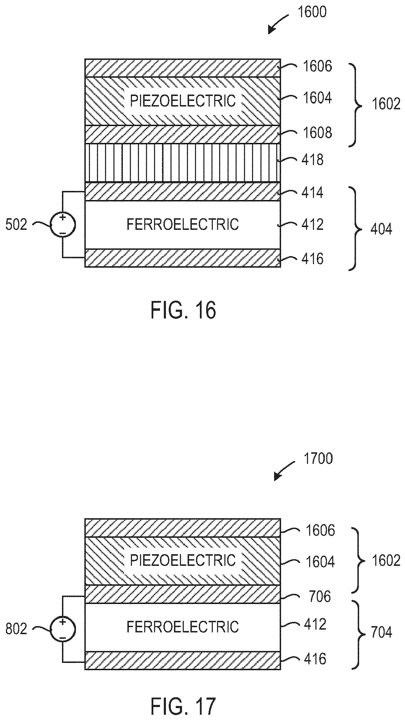

FIG. 16 illustrates an example fifth reconfigurable BAW device 1600 in accordance with embodiments of the disclosure. The fifth reconfigurable BAW device 1600 includes a BAW resonator 1602 stacked vertically over the second reconfigurable BAW resonator 404. The BAW resonator 1602 includes a piezoelectric layer 1604 positioned between a fifth electrode 1606 and a sixth electrode 1608. Non-limiting examples of a piezoelectric material for the piezoelectric layer 1604 include AlN, ScAlN, ZnO, or other appropriate piezoelectric material. Example materials for the fifth electrode 1606 and the sixth electrode 1608 include, but are not limited to, tungsten, aluminum, copper, molybdenum, or combinations thereof.

The second reconfigurable BAW resonator 404 includes the second ferroelectric layer 412 positioned between the third electrode 414 and the fourth electrode 416. One or more characteristics of the second ferroelectric layer 412 may be set or adjusted by adjusting the output (e.g., voltage output) of the second power supply 502. Depending on the output of the second power supply 502 (e.g., a non-zero output), the second power supply 502 creates an electric field across the second ferroelectric layer 412, which changes the one or more material properties of the second ferroelectric layer 412 (e.g., the electromechanical coupling coefficient). Based on the changes in the one or more material properties of the second ferroelectric layer 412, the transmission response of the fifth reconfigurable BAW device 1600 changes. In other embodiments, the first reconfigurable BAW resonator 402 (FIG. 4) can be stacked vertically over the BAW resonator 1602 (in lieu of the second reconfigurable BAW resonator 404 or in addition to the second reconfigurable BAW resonator 404.

The coupling layer 418 is between the sixth electrode 1608 and the third electrode 414. In other embodiments, the coupling layer 418 is included in a coupling structure that includes multiple coupling layers (e.g., the coupling structure 1502 in FIG. 15).

FIG. 17 illustrates an example sixth reconfigurable BAW device 1700 in accordance with embodiments of the disclosure. The sixth reconfigurable BAW device 1700 includes the BAW resonator 1602 stacked vertically over the second reconfigurable BAW transducer 704. The BAW transducer 1702 includes the piezoelectric layer 1604 positioned between the fifth electrode 1606 and the intermediate electrode 706. The second reconfigurable BAW transducer 704 includes the second ferroelectric layer 412 positioned between the intermediate electrode 706 and the fourth electrode 416. Depending on the output of the fourth power supply 802 (e.g., a non-zero output), the fourth power supply 802 creates an electric field across the second ferroelectric layer 412, which changes the one or more material properties (e.g., the electromechanical coupling coefficient) of the second ferroelectric layer 412. Based on the change in the one or more material properties of the second ferroelectric layer 412, the output of the sixth reconfigurable BAW device 1700 changes. In other embodiments, the first reconfigurable BAW transducer 702 (FIG. 4) can be stacked vertically over the BAW resonator 1602 (in lieu of the second reconfigurable BAW transducer 704 or in addition to the second reconfigurable BAW transducer 704).

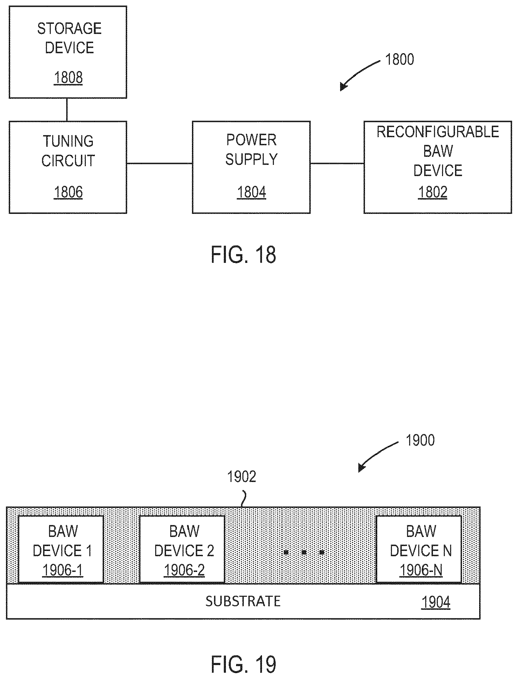

FIG. 18 illustrates an example system 1800 that includes one or more reconfigurable BAW devices in accordance with embodiments of the disclosure. The representative system 1800 includes a reconfigurable BAW device 1802 operably connected to a power supply 1804. A tuning circuit 1806, such as a processing device, can be operable to control the output of the power supply 1804. The tuning circuit 1806 may output a signal that is received by the power supply 1804 and causes the power supply 1804 to output a signal (e.g., voltage signal) that adjusts the response of the reconfigurable BAW device 1802. The reconfigurable BAW device 1802 may include one or more reconfigurable BAW devices. The reconfigurable BAW device 1802 may be implemented as shown in FIGS. 4-9 or in FIGS. 13-17. Additionally, the power supply 1804 represents one or more power supplies.

In certain embodiments, one or more storage devices (collectively referred to as storage device 1808) is operably connected to the tuning circuit 1806. The storage device 1808 is operable to store processor-executable instructions that when executed by the tuning circuit 1806, cause the tuning circuit 1806 to output a signal that causes the power supply 1804 to output a signal that changes the response of the reconfigurable BAW device 1802. In a non-limiting nonexclusive example, the tuning circuit 1806 can be any suitable processing device, such as a microprocessor, a field-programmable gate array, an application-specific integrated circuit, a central processing unit, or combinations thereof. The storage device 1808 may be a volatile memory (e.g., random access memory), a non-volatile memory (e.g., read-only memory), or combinations thereof.

FIG. 19 illustrates an example integrated circuit 1900 that includes multiple reconfigurable BAW devices in accordance with embodiments of the disclosure. The integrated circuit 1900 includes circuitry 1902 arranged over a substrate 1904. The circuitry 1902 includes N reconfigurable BAW devices 1906-1, 1906-2, ..., 1906-N, where N is equal to or greater than one. In the illustrated example, the circuitry 1902 includes three reconfigurable BAW devices, but other embodiments can include any number of reconfigurable BAW devices.

Each reconfigurable BAW device 1906-1, 1906-2, ..., 1906-N can be implemented as a reconfigurable BAW device shown in FIGS. 4-9 or in FIGS. 13-17. In some embodiments, the reconfigurable BAW devices 1906-1, 1906-2, ..., 1906-N can be operable to have different responses (e.g., different bandwidths). Additionally, during operation of the reconfigurable BAW devices 1906-1, 1906-2, ..., 1906-N, the "on" and the "off" states of the reconfigurable BAW devices 1906-1, 1906-2, ..., 1906-N can change over time. The transmission phase of that reconfigurable BAW device can also change over time (e.g., FIG. 10).

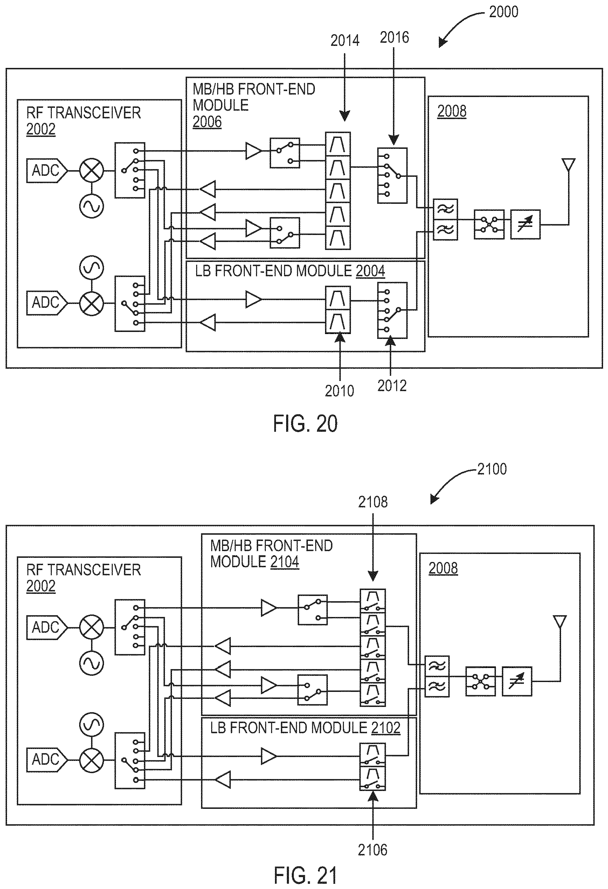

FIG. 20 illustrates an example conventional radio frequency (RF) front-end system 2000 that includes BAW devices 2010, 2014. The conventional RF system 2000 includes RF transceiver circuitry 2002, low band (LB) circuitry 2004, middle band and/or high band (MB/HB) circuitry 2006, and output circuitry 2008. The LB circuitry 2004 includes the BAW devices 2010 operably connected to one or more inputs of a switch 2012. An output of the switch 2012 is operably connected to the output circuitry 2008. The MB/HB circuitry 2006 includes BAW devices 2014 operably connected to one or more inputs of a switch 2016. An output of the switch 2016 is operably connected to the output circuitry 2008.

Embodiments disclosed herein enable the BAW devices 2010 and the switch 2012 to be combined into one or more reconfigurable BAW devices. Similarly, the BAW devices 2014 and the switch 2016 may be combined into one or more reconfigurable BAW devices. FIG. 21 illustrates an example RF front-end system 2100 that includes reconfigurable BAW devices 2106, 2108 in accordance with embodiments of the disclosure. The RF system 2100 includes the RF transceiver circuitry 2002, LB circuitry 2102, MB/HB circuitry 2104, and the output circuitry 2008. The LB circuitry 2102 includes reconfigurable BAW devices 2106 operably connected to the output circuitry 2008. The MB/HB circuitry 2104 includes reconfigurable BAW devices 2108 operably connected to the output circuitry 2008. Although the LB circuitry 2102 depicts two (2) reconfigurable BAW devices and the MB/HB circuitry 2104 shows five (5) reconfigurable BAW devices, other embodiments can include any number of BAW devices in the LB circuitry 2102 and/or in the MB/HB circuitry 2104.

Therefore, from one perspective, there have been described approaches for reconfigurable bulk acoustic wave (BAW) devices that include one or more ferroelectric materials as the transduction layer(s). A polarization state of at least one of the ferroelectric material(s) is adjusted by applying a bias voltage across electrodes of the BAW device. The application of the bias voltage can change one or more properties of the ferroelectric material, which in turn may change a response of the BAW device.

Further examples are set out in the following numbered clauses.

Clause 1 A reconfigurable bulk acoustic wave (BAW) device, comprising: a first reconfigurable BAW resonator; and a second reconfigurable BAW resonator stacked vertically over or under the first reconfigurable BAW resonator, wherein the first reconfigurable BAW resonator and the second reconfigurable BAW resonator each include: a first electrode; a second electrode; and a ferroelectric layer between the first electrode and the second electrode.

Clause 2. The reconfigurable BAW device of clause 1, wherein the first electrode and the second electrode each comprise tungsten, aluminum, copper, molybdenum, or combinations thereof.

Clause 3. The reconfigurable BAW device of clause 1 or 2, wherein the ferroelectric layer comprises lead titanate (PbTiO3), lead zirconate titanate (PZT), scandium aluminum nitride (ScAlN), barium titanate (BTO), barium strontium titanate (BST), or Hafnium Oxide (HfO).

Clause 4. The reconfigurable BAW device of clause 1, 2 or 3, further comprising a direct current power supply operably connected to at least one of the first reconfigurable BAW resonator or the second reconfigurable BAW resonator.

Clause 5. The reconfigurable BAW device of any of clauses 1 to 4, further comprising a coupling layer between the first reconfigurable BAW resonator and the second reconfigurable BAW resonator.

Clause 6. The reconfigurable BAW device of clause 5, wherein the coupling layer comprises silicon dioxide (SiO2) or silicon nitride (SiN), Aluminum (Al), tungsten (W), Aluminum nitride (AlN).

Clause 7. A reconfigurable transducer, comprising: a first reconfigurable transducer stacked vertically over a second reconfigurable transducer; and an intermediate electrode between the first reconfigurable transducer and the second reconfigurable transducer, wherein: the first reconfigurable transducer comprises: a first electrode; a first ferroelectric layer between the first electrode and the intermediate electrode; and the second reconfigurable transducer comprises a second ferroelectric layer between the intermediate electrode and a second electrode.

Clause 8. The reconfigurable transducer of clause 7, wherein the first electrode, the intermediate electrode, and the second electrode each comprises tungsten, aluminum, copper, molybdenum, or combinations thereof.

Clause 9. The reconfigurable transducer of clause 7 or 8, wherein the first ferroelectric layer and the second ferroelectric layer each comprises lead titanate (PbTiO3), scandium aluminum nitride (ScAlN), lead zirconate titanate (PZT), barium titanate (BTO), barium strontium titanate (BST), or Hafnium Oxide (HfO).

Clause 10. The reconfigurable transducer of clause 7, 8 or 9, further comprising a direct current power supply operably connected to the first electrode and the intermediate electrode.

Clause 11. The reconfigurable transducer of any of clauses 7 to 10, further comprising a direct current power supply operably connected to the intermediate electrode and the second electrode.

Clause 12. The reconfigurable transducer of any of clauses 7 to 11, further comprising a reflector arranged over the first electrode of the first reconfigurable transducer and/or the second electrode of the second reconfigurable transducer.

Clause 13. A reconfigurable filter, comprising: a first reconfigurable BAW resonator; a second reconfigurable BAW resonator stacked vertically over or under the first reconfigurable BAW resonator, and a coupling structure comprising one or more coupling layers between the first reconfigurable BAW resonator and the second reconfigurable BAW resonator, wherein the first reconfigurable BAW resonator and the second reconfigurable BAW resonator each includes: a first electrode; a second electrode; and a ferroelectric layer between the first electrode and the second electrode; and a reflector between the second reconfigurable BAW resonator and a substrate.

Clause 14. The reconfigurable filter of clause 13, wherein the first electrode and the second electrode each comprises tungsten, aluminum, copper, molybdenum, or combinations thereof.

Clause 15. The reconfigurable filter of clause 13 or 14, wherein the ferroelectric layer comprises lead titanate (PbTiO3), lead zirconate titanate (PZT), scandium aluminum nitride (ScAlN), barium titanate (BTO), barium strontium titanate (BST), or Hafnium Oxide (HfO).

Clause 16. The reconfigurable filter of clause 13, 14 or 15, further comprising a direct current power supply operably connected to the first electrode and the second electrode of the first reconfigurable BAW resonator.

Clause 17. The reconfigurable filter of any of clauses 13 to 16, further comprising a direct current power supply operably connected to the first electrode and the second electrode of the second reconfigurable BAW resonator.

Clause 18. The reconfigurable filter of any of clauses 13 to 17, wherein: the reflector is a first reflector; and the reconfigurable filter further comprises a second reflector over or under the first reconfigurable BAW resonator.

Clause 19. The reconfigurable filter of clause 18, wherein the first electrode and the second electrode each comprises tungsten, aluminum, copper, molybdenum, or combinations thereof.

Clause 20. The reconfigurable filter of clause 18 or 19, wherein the ferroelectric layer comprises lead titanate (PbTiO3), lead zirconate titanate (PZT), scandium aluminum nitride (ScAlN), barium titanate (BTO), barium strontium titanate (BST), or Hafnium Oxide (HfO).

It is contemplated that any of the foregoing aspects, and/or various separate aspects and features as described herein, may be combined for additional advantage. Any of the various embodiments as disclosed herein may be combined with one or more other disclosed embodiments unless indicated to the contrary herein.

Those skilled in the art will recognize improvements and modifications to the illustrative embodiments of the present disclosure. All such improvements and modifications are considered within the scope of the concepts disclosed herein and the claims that follow.

**Claims**

1. A reconfigurable bulk acoustic wave (BAW) device, comprising:

a first reconfigurable BAW resonator; and a second reconfigurable BAW resonator stacked vertically over or under the first reconfigurable BAW resonator, wherein the first reconfigurable BAW resonator and the second reconfigurable BAW resonator each include:

    a first electrode;
    a second electrode; and
    a ferroelectric layer between the first electrode and the second electrode.

2. The reconfigurable BAW device of claim 1, wherein the first electrode and the second electrode each comprise tungsten, aluminum, copper, molybdenum, or combinations thereof.

3. The reconfigurable BAW device of claim 1 or 2, wherein the ferroelectric layer comprises lead titanate ($PbTiO_3$), lead zirconate titanate (PZT), scandium aluminum nitride (ScAlN), barium titanate (BTO), barium strontium titanate (BST), or Hafnium Oxide (HfO).

4. The reconfigurable BAW device of claim 1, 2 or 3, further comprising a direct current power supply operably connected to at least one of the first reconfigurable BAW resonator or the second reconfigurable BAW resonator.

5. The reconfigurable BAW device of any of claims 1 to 4, further comprising a coupling layer between the first reconfigurable BAW resonator and the second reconfigurable BAW resonator.

6. The reconfigurable BAW device of claim 5, wherein the coupling layer comprises silicon dioxide ($SiO_2$) or silicon nitride (SiN), Aluminum (Al), tungsten (W), Aluminum nitride (AlN).

7. A reconfigurable transducer, comprising:

    a first reconfigurable transducer stacked vertically over a second reconfigurable transducer; and
    an intermediate electrode between the first reconfigurable transducer and the second reconfigurable transducer, wherein:

        the first reconfigurable transducer comprises:

            a first electrode;
            a first ferroelectric layer between the first electrode and the intermediate electrode; and

        the second reconfigurable transducer comprises a second ferroelectric layer between the intermediate electrode and a second electrode.

8. The reconfigurable transducer of claim 7, wherein the first electrode, the intermediate electrode, and the second electrode each comprises tungsten, aluminum, copper, molybdenum, or combinations thereof.

9. The reconfigurable transducer of claim 7 or 8, wherein the first ferroelectric layer and the second ferroelectric layer each comprises lead titanate ($PbTiO_3$), scandium aluminum nitride (ScAlN), lead zirconate titanate (PZT), barium titanate (BTO), barium strontium titanate (BST), or Hafnium Oxide (HfO).

10. The reconfigurable transducer of claim 7, 8, or 9, further comprising a direct current power supply operably connected to the first electrode and the intermediate electrode.

11. The reconfigurable transducer of any of claims 7 to 10, further comprising a direct current power supply operably connected to the intermediate electrode and the second electrode.

12. The reconfigurable transducer of any of claims 7 to 11, further comprising a reflector arranged over the first electrode of the first reconfigurable transducer and/or the second electrode of the second reconfigurable transducer.

13. A reconfigurable filter, comprising:

    the reconfigurable BAW device of any of claims 1 to 4;
    a coupling structure comprising one or more coupling layers between the first reconfigurable BAW resonator and the second reconfigurable BAW resonator; and
    a reflector between the second reconfigurable BAW resonator and a substrate.

14. The reconfigurable filter of claim 13, wherein:

    the reflector is a first reflector; and
    the reconfigurable filter further comprises a second reflector over or under the first reconfigurable BAW resonator.

FIG. 1

FIG. 2

FIG. 3

400

408

402 { 406    FERROELECTRIC

410

418

404 { 414

412    FERROELECTRIC

416

FIG. 4

400

500    408

↑ P1    FERROELECTRIC    406    } 402

410

418

502    414

↑ P2    FERROELECTRIC    412    } 404

416

FIG. 5

400

500    408

↑ P1    FERROELECTRIC    406    } 402

410

418

414

502    ↓ P3    FERROELECTRIC    412    } 404

416

FIG. 6

700

702 { 408
406 FERROELECTRIC
706

704 { 412 FERROELECTRIC
416

FIG. 7

700

800 (+/−)  ↑ P1    FERROELECTRIC    408 } 702
406
706

802 (−/+)  ↑ P2    FERROELECTRIC    412 } 704
416

FIG. 8

700

800 (+/−)  ↑ P1    FERROELECTRIC    408 } 702
406
706

802 (−/+)  ↓ P3    FERROELECTRIC    412 } 704
416

FIG. 9

FIG. 10

FIG. 11

FIG. 12

FIG. 13

EP 4 346 100 A1

FIG. 14

1500

500

FERROELECTRIC — 406 402
— 408
— 410

1502-1

1502

1502-N

502

FERROELECTRIC — 412 404
— 414
— 416

FIG. 15

1600

1606
PIEZOELECTRIC 1604
1602
1608
418
414
502 FERROELECTRIC 412
404
416

FIG. 16

1700

1606
PIEZOELECTRIC 1604
1602
706
802 FERROELECTRIC 412
704
416

FIG. 17

```
┌─────────────┐
│   STORAGE   │
│   DEVICE    │                              1800
│    1808     │                       ╱
└──────┬──────┘                      ↙
       │
┌──────┴──────┐      ┌─────────────┐      ┌─────────────────┐
│   TUNING    │      │    POWER    │      │  RECONFIGURABLE │
│   CIRCUIT   │──────│    SUPPLY   │──────│       BAW       │
│    1806     │      │    1804     │      │      DEVICE     │
│             │      │             │      │      1802       │
└─────────────┘      └─────────────┘      └─────────────────┘
```

FIG. 18

```
                                         1900
                                  ╱
                     1902        ↙
                      ╲
┌──────────────────────────────────────────────────────────┐
│ ┌──────────┐  ┌──────────┐              ┌──────────┐      │
│ │   BAW    │  │   BAW    │              │   BAW    │      │
│ │ DEVICE 1 │  │ DEVICE 2 │   ▪ ▪ ▪      │ DEVICE N │      │
│ │  1906-1  │  │  1906-2  │              │  1906-N  │      │
│ └──────────┘  └──────────┘              └──────────┘      │
├──────────────────────────────────────────────────────────┤
│              SUBSTRATE                          1904       │
└──────────────────────────────────────────────────────────┘
```

FIG. 19

2014  2016  2000

RF TRANSCEIVER 2002

ADC

MB/HB FRONT-END MODULE 2006

LB FRONT-END MODULE 2004

2008

2010  2012

FIG. 20

2108  2100

RF TRANSCEIVER 2002

ADC

MB/HB FRONT-END MODULE 2104

LB FRONT-END MODULE 2102

2008

2106

FIG. 21

Europäisches
Patentamt
European
Patent Office
Office européen
des brevets

# EUROPEAN SEARCH REPORT

**Application Number**

EP 23 20 0357

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/304412 A1 (ZHANG HAO [CN]) 15 December 2011 (2011-12-15) | 1-3,5 | INV. H03H9/00 |
| Y | * figure 2A * | 4 | H03H9/02 H03H9/205 |
| X | US 8 390 397 B2 (JAMNEALA TIBERIU [US]; RUBY RICHARD C [US] ET AL.) 5 March 2013 (2013-03-05) | 1-3,5,6 | H03H9/58 |
| Y | * paragraph [0030] - paragraph [0031]; claim 7; figure 1A * | 4 | |
| X | CN 113 972 901 A (HUAWEI TECH CO LTD) 25 January 2022 (2022-01-25) | 1-3,5,6 | |
| Y | * paragraph [0101] - paragraph [0104]; figure 1 * | 4 | |
| X | US 2021/384887 A1 (MORTAZAWI AMIR [US] ET AL) 9 December 2021 (2021-12-09) * paragraph [0046] - paragraph [0061]; figures 4A,4B,8A * | 7-14 | |
| X | US 2013/135264 A1 (BLACK JUSTIN PHELPS [US]) 30 May 2013 (2013-05-30) * paragraph [0111]; figures 7A, 18I * | 7-14 | TECHNICAL FIELDS SEARCHED (IPC) |
| | | | H03H |
| X | KOOHI MILAD ZOLFAGHARLOO ET AL: "Intrinsically Switchable Miniature Ferroelectric Stacked Crystal Filters", 2019 IEEE MTT-S INTERNATIONAL MICROWAVE SYMPOSIUM (IMS), IEEE, 2 June 2019 (2019-06-02), pages 661-664, XP033579544, [retrieved on 2019-04-26] * abstract; figure 4(b) * | 7-12 | |
| Y | US 2010/309061 A1 (SINHA DHIRAJ [GB]) 9 December 2010 (2010-12-09) * paragraph [0112] * | 4 | |

The present search report has been drawn up for all claims

| Place of search | Date of completion of the search | Examiner |
|---|---|---|
| Munich | 8 February 2024 | Schnabel, Florian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 20 0357

This annex lists the patent family members relating to the patent documents cited in the above-mentioned European search report.
The members are as contained in the European Patent Office EDP file on
The European Patent Office is in no way liable for these particulars which are merely given for the purpose of information.

08-02-2024

| Patent document cited in search report | | Publication date | Patent family member(s) | | Publication date |
|---|---|---|---|---|---|
| US 2011304412 | A1 | 15-12-2011 | NONE | | |
| US 8390397 | B2 | 05-03-2013 | GB | 2479240 A | 05-10-2011 |
| | | | US | 2011237204 A1 | 29-09-2011 |
| CN 113972901 | A | 25-01-2022 | NONE | | |
| US 2021384887 | A1 | 09-12-2021 | NONE | | |
| US 2013135264 | A1 | 30-05-2013 | US | 2013135264 A1 | 30-05-2013 |
| | | | WO | 2013082044 A1 | 06-06-2013 |
| US 2010309061 | A1 | 09-12-2010 | CN | 101971493 A | 09-02-2011 |
| | | | EP | 2232701 A1 | 29-09-2010 |
| | | | JP | 2011511498 A | 07-04-2011 |
| | | | US | 2010309061 A1 | 09-12-2010 |
| | | | WO | 2009081089 A1 | 02-07-2009 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63411404